(19) Europäisches Patentamt
European Patent Office
Office européen des brevets

(11) **EP 2 896 969 B1**

(12) **FASCICULE DE BREVET EUROPEEN**

(45) Date de publication et mention
de la délivrance du brevet:
**22.06.2016 Bulletin 2016/25**

(51) Int Cl.:
**G01N 29/00** *(2006.01)*    **G01R 31/10** *(2006.01)*
**G01R 31/12** *(2006.01)*    **G01R 31/08** *(2006.01)*

(21) Numéro de dépôt: **15150994.0**

(22) Date de dépôt: **13.01.2015**

(54) **Procédé et système de protection contre les arcs électriques mettant en oeuvre une modulation spécifique à un module de l'onde acoustique accompagnant un arc électrique**

Verfahren und System zum Schutz gegen elektrische Lichtbögen, bei dem eine spezifische Modulation an einem Modul der Schallwelle vorgenommen wird, die mit einem elektrischen Lichtbogen einhergeht

Method and system for protecting against electric arcs implementing a specific modulation to a module of the acoustic wave accompanying an electric arc

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.01.2014 FR 1450316**

(43) Date de publication de la demande:
**22.07.2015 Bulletin 2015/30**

(73) Titulaire: **Commissariat à l'Énergie Atomique et aux Énergies Alternatives
75015 Paris (FR)**

(72) Inventeurs:
• **Heiries, Vincent
38430 SAINT-JEAN DE MOIRANS (FR)**
• **Lacoume, Jean-Louis
38610 GIERES (FR)**
• **Perichon, Pierre
38500 VOIRON (FR)**

(74) Mandataire: **Brevalex
95, rue d'Amsterdam
75378 Paris Cedex 8 (FR)**

(56) Documents cités:
**DE-A1-102011 009 512    US-A- 4 291 204
US-A1- 2012 006 117    US-A1- 2012 327 745**

**Description**

**DOMAINE TECHNIQUE**

Le domaine de l'invention est celui des systèmes électriques, notamment haute tension, à l'intérieur desquels peuvent naitre des arcs électriques : armoires électriques, transformateurs, câblages, batteries.

L'invention concerne plus particulièrement une technique de détection et de localisation d'arcs électriques basée sur une mesure de l'onde acoustique générée par un arc électrique.

**ÉTAT DE LA TECHNIQUE ANTÉRIEURE**

Dans les systèmes électriques, la rupture d'un câble ou une connectique défectueuse peut entraîner un arc électrique qui, s'il est entretenu, va causer des dégradations. Dans le cas de systèmes fonctionnant en courant continu, comme les batteries par exemple, l'arc électrique formé est entretenu et peut être à l'origine d'échauffements importants conduisant à un départ d'incendie.

La détection précoce d'un arc électrique est ainsi un enjeu majeur pour la sureté de fonctionnement des systèmes électriques, et en particulier des batteries.

Une méthode générique de détection d'arcs est basée sur des mesures de courant et de tension qui se retrouvent perturbées par l'apparition d'un arc électrique. Par un traitement approprié de ces mesures, il est possible de détecter l'apparition de l'arc électrique. Cette solution est cependant inapplicable pour certaines applications, comme par exemple les batteries dans lesquelles les accumulateurs électrochimiques présentent une impédance très faible qui atténue la signature en tension des arcs électriques. Pour pallier ce problème de détection, un grand nombre de capteurs devrait être utilisé, ce qui induirait un coût inapproprié.

Une autre méthode de détection d'arcs repose sur la mesure du rayonnement optique. Cette solution est cependant inapplicable dans des applications où le capteur de rayonnement est incapable de détecter le rayonnement de certaines connexions occultées par un boîtier de protection de forme complexe ou disposées au coeur d'un module et occultées par d'autres composants.

Une autre méthode de détection d'arcs, utilisée dans les panneaux photovoltaïques, est basée sur la mesure du champ électromagnétique et l'identification d'une signature spécifique. Une telle détection induit un nombre important de fausses alarmes en particulier lorsque le bruit électromagnétique environnant est important. Par ailleurs, une telle détection est fortement affectée par tout écran à la propagation des ondes électromagnétiques. En outre, une telle détection présente un temps de réponse relativement long.

Une autre méthode de détection d'arcs électriques est basée sur la détection de l'onde acoustique qui se manifeste en présence d'un arc électrique. On connaît ainsi de la demande de brevet US 2012/0006117 A1 une technique consistant à appliquer un signal électrique dans un câble électrique enterré. Ce signal va engendrer un arc électrique au niveau d'un défaut du câble, cet arc électrique déclenchant un bruit de décharge sous la forme d'un signal acoustique. Ce signal acoustique est détecté en surface et permet de localiser le défaut.

On connaît également de la demande de brevet US 2012/327745 A1 un système de surveillance de pannes dans une station électrique exploitant un ensemble de capteurs acoustiques et dans lequel les signaux acoustiques mesurés sont comparés avec des signatures caractéristiques de pannes. Et l'on connaît de la demande DE 10 2011 009512 A1 un procédé de localisation de défaut par génération d'une décharge électrique au niveau du défaut au moyen d'une combinaison d'une pulse haute tension et d'une pulse basse tension, et par détection acoustique de la décharge

Les systèmes électriques se décomposent souvent en une pluralité de modules, chaque module étant susceptible d'être défectueux et d'engendrer un arc électrique. Par module, on entend un sous-ensemble d'un système électrique, par exemple un équipement électrique particulier, un câble, une connectique, une cellule, ou encore un groupe de tels éléments.

Si les méthodes de détection présentées ci-dessus permettent de détecter un arc électrique généré dans un système électrique, elles ne permettent pas d'identifier le module défectueux lieu de naissance de l'arc électrique. Or une telle identification est souhaitable, notamment à des fins de maintenance ou encore pour isoler le module défectueux tout en continuant à alimenter les autres modules du système pour en assurer la continuité de service.

**EXPOSÉ DE L'INVENTION**

L'invention vise à répondre à cette problématique d'identification d'un module défectueux lieu de naissance d'un arc électrique dans un système électrique décomposé en une pluralité de modules. Elle propose pour ce faire un procédé de localisation de défauts dans un système électrique comprenant une pluralité de modules pouvant être alimentés indépendamment en courant, caractérisé en ce qu'il comporte les étapes suivantes :

- application à chacun des modules d'un courant modulé par un signal spécifique au module,
- mesure d'un signal acoustique qui accompagne un arc électrique généré par un module défectueux,
- identification d'une signature de l'un des signaux spécifiques dans le signal acoustique mesuré pour identifier le module défectueux.

Certains aspects préférés mais non limitatifs de procédé sont les suivants :

- l'identification d'une signature de l'un des signaux spécifiques dans le signal acoustique mesuré comprend une corrélation du signal acoustique mesuré avec chacun des signaux spécifiques;
- l'identification du module défectueux comprend l'identification d'un pic d'autocorrélation parmi les résultats de corrélation du signal acoustique mesuré avec chacun des signaux spécifiques ;
- il comprend en outre une étape de localisation de l'arc électrique par détermination, à partir des résultats d'autocorrélation du signal acoustique mesuré avec le signal spécifique associé au module défectueux, du temps de propagation de l'onde acoustique depuis l'arc électrique jusqu'à un capteur acoustique réalisant la mesure du signal acoustique ;
- il comprend la détermination du temps de propagation de l'onde acoustique depuis l'arc électrique jusqu'à au moins trois capteurs acoustiques réalisant la mesure du signal acoustique, et une triangulation des temps de propagation ainsi déterminés.
- un signal spécifique à un module est une séquence de code pseudo-aléatoire, par exemple un code de Gold ou un code de Kasami.
- chacun des signaux spécifiques est mis en forme par une forme d'onde rectangulaire avant corrélation avec le signal acoustique mesuré.
- il comprend les étapes préalables de détection d'un arc électrique, et de coupure de l'alimentation du système électrique.
- le courant modulé appliqué à chacun des modules est superposé à un courant de fonctionnement du système électrique.

L'invention porte également sur un système électrique comprenant une pluralité de modules pouvant être alimentés indépendamment en courant, caractérisé en ce qu'il comporte en outre :

- un module d'application à chacun des modules d'un courant modulé par un signal spécifique au module,
- un capteur acoustique permettant la mesure d'un signal acoustique qui accompagne un arc électrique généré par un module défectueux,
- une unité de traitement configurée pour identifier une signature de l'un des signaux spécifiques dans le signal acoustique mesuré par le capteur acoustique pour identifier le module défectueux.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

- la figure 1 est un schéma représentant un exemple de mise en oeuvre d'une localisation de défauts dans un système électrique selon l'invention ;
- la figure 2 est un diagramme représentant les étapes d'un exemple de mise en oeuvre d'un procédé de localisation de défauts dans un système électrique selon l'invention ;
- la figure 3 est un schéma illustrant un mode de réalisation possible d'identification d'une signature d'un signal spécifique dans le signal acoustique mesuré.

## EXPOSÉ DÉTAILLÉ DE MODES DE RÉALISATION PARTICULIERS

L'invention propose de détecter l'apparition d'arcs électriques dans un système électrique comprenant une pluralité de modules pouvant être alimentés indépendamment en courant, et plus particulièrement d'identifier lequel de ces modules est à l'origine de l'arc électrique.

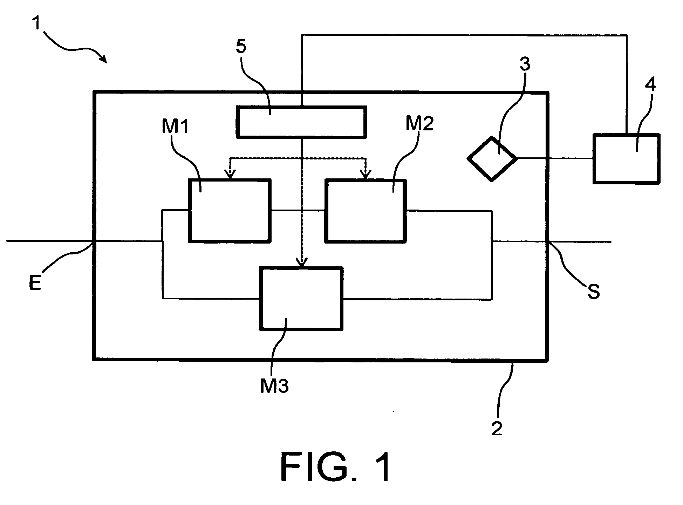

La figure 1 est un schéma représentant un exemple d'un tel système électrique 1. Le système électrique 1 comporte un boîtier de protection 2 à l'intérieur duquel sont logés différents sous-ensembles ou modules M1-M3. A titre d'exemple purement illustratif, on a représenté sur la figure 1, deux modules M1 et M2 connectés électriquement en série entre une borne d'entrée E et une borne de sortie S du système électrique 1, et un module M3 connecté en parallèle des modules en série M1 et M2 entre les bornes d'entrée E et de sortie S.

Un arc électrique, série ou parallèle, est susceptible de naître lorsque l'un de ces modules M1-M3 est défectueux. Cet arc s'accompagne de l'émission d'une onde acoustique.

Le système électrique 1 comporte par ailleurs un capteur acoustique 3, par exemple logé dans le boîtier de protection 2, qui permet de mesurer un signal acoustique qui accompagne un arc électrique généré par un module M1-M3 défectueux. Le capteur acoustique 3 est par exemple un microphone, en particulier lorsque le milieu de propagation de l'onde acoustique est l'air. Il est préférentiellement configuré pour mesurer des ultrasons dans une bande comprise entre 60 et 300 kHz, de préférence entre 60 et 150 kHz. Le capteur acoustique 3 peut prendre d'autres formes, comme par exemple celle d'un capteur piézoélectrique pouvant notamment être utilisé pour mesurer un signal acoustique se propageant à l'intérieur d'un câble.

Le système électrique 1 comporte par ailleurs une unité de traitement 4 reliée au capteur acoustique 3 pour assurer l'indentification d'un module défectueux comme cela sera détaillé par la suite.

Le système électrique 1 comporte également un module d'application d'un courant 5 à chacun des modules M1-M3. Ce module 5 est plus particulièrement configuré pour appliquer à chacun des modules un courant modulé par un signal spécifique au module.

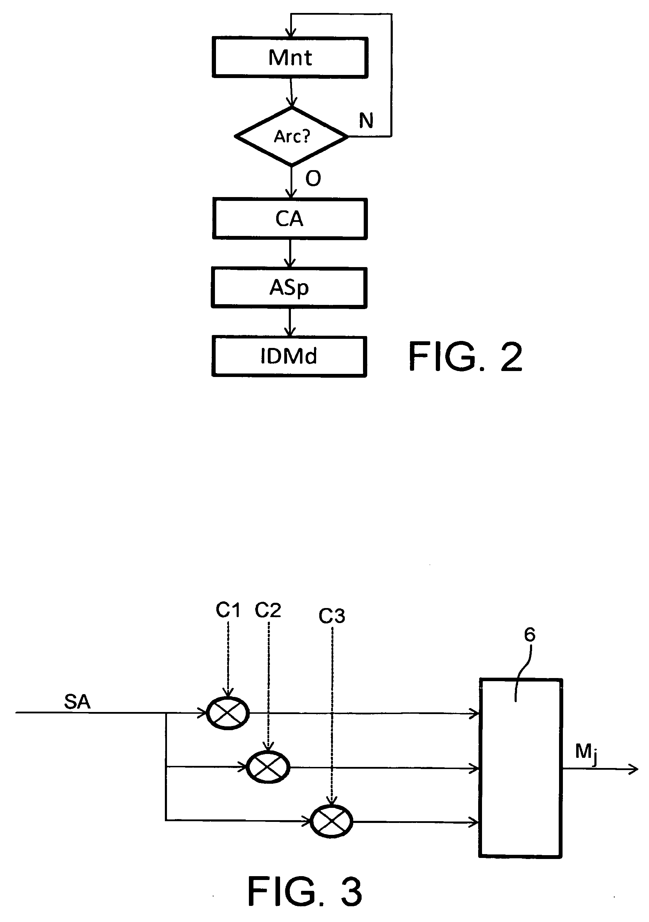

La figure 2 illustre un mode de réalisation possible de la localisation de défauts dans le système électrique 1 selon l'invention et qui consiste à identifier le module défectueux à l'origine d'un arc électrique.

Dans une première étape « Mnt », il est procédé à la surveillance de la survenance d'un arc électrique dans le système électrique au moyen d'un détecteur d'arc relié à l'unité de traitement 4 ou à une unité de traitement dédiée. Ce détecteur peut être le capteur acoustique 4 lui-même, ou bien tout autre type de détecteur comme par exemple un capteur électromagnétique.

Lorsqu'un arc généré par un module défectueux est détecté, il est procédé, dans une deuxième étape « CA », à la coupure de l'alimentation du système électrique ou d'une partie de celui-ci lorsque la détection de l'arc s'accompagne d'une localisation de celui-ci. Cette coupure interrompt l'arc électrique.

Puis dans une troisième étape « ASp », il est procédé au rétablissement du courant aux bornes des différents modules M1-M3 du système électrique au moyen du module d'application d'un courant 5. Ce module 5 vient plus précisément appliquer à chacun des modules M1-M3 un courant modulé par un signal spécifique au module, respectivement C1-C3 pour les modules M1-M3. Les paramètres des modulations de courant appliquées aux différents modules peuvent être fournis au module d'application d'un courant 5 par l'unité de traitement 4. A contrario, le module d'application d'un courant 5 peut fournir ces paramètres de modulation à l'unité de traitement 4. Ou encore, ces paramètres de modulation sont connus par construction du module d'application d'un courant 5 et de l'unité de traitement 4.

Suite au rétablissement du courant, l'arc est alors de nouveau généré au niveau du module défectueux et la modulation spécifique du courant appliqué au module défectueux se traduit par une modulation également spécifique de l'émission acoustique de l'arc (phénomène physique connu sous le nom d'arc chantant).

Dans une quatrième étape « IDMd », il est procédé par l'unité de traitement 4 à l'identification d'une signature de l'un des signaux spécifiques de modulation dans le signal acoustique mesuré par le capteur acoustique 3, et ainsi à l'identification du module défectueux.

Comme représenté sur la figure 3, l'étape d'identification « IDMd » peut comprendre une corrélation du signal acoustique SA mesuré par le capteur acoustique 3 avec chacun des signaux spécifiques C1-C3. Un circuit d'analyse 6 des résultats des différentes corrélations réalise une recherche de pic d'autocorrélation parmi ces différents résultats, notamment par comparaison avec un seuil prédéterminé. Lorsqu'un tel pic est identifié, le circuit d'analyse 6 indique lequel des modules est défectueux, à savoir le module Mj associé au signal spécifique Cj modulant la signature acoustique de l'arc électrique.

La recherche du pic d'autocorrélation permet également au circuit d'analyse 6 de mesurer le temps de propagation de l'onde acoustique depuis l'arc la générant jusqu'au capteur acoustique 3. Dans un mode de réalisation possible de l'invention, on a recours à au moins trois capteurs acoustiques 3 ce qui permet de déterminer la localisation précise de l'arc électrique par une technique de triangulation des temps de propagation de l'onde acoustique de l'arc électrique vers chacun des capteurs acoustiques 4. Cette localisation exploite des mesures non ambiguës de temps de propagation et présente ainsi l'avantage d'être plus précise que des techniques de localisation exploitant les différences de temps d'arrivée du signal acoustique jusqu'à chacun des capteurs.

Le signal acoustique SA étant intégré lors de la corrélation sur toute la durée d'un signal spécifique, un gain de traitement significatif est apporté, ce qui améliore de manière significative la fiabilité et la sensibilité de l'identification du module défectueux et de la localisation de l'arc électrique.

Les signaux spécifiques C1-C3 sont de préférence mis en forme avant corrélation avec le signal acoustique SA pour améliorer la détection du pic d'autocorrélation, par exemple au moyen d'une forme d'onde, notamment une forme d'onde rectangulaire, grâce à laquelle les signaux spécifiques présentent des fronts montants et descendants raides.

Dans un autre mode de réalisation de l'invention, il n'est pas procédé aux étapes de surveillance « Mnt » de la survenance d'un arc électrique dans le système électrique et de coupure de l'alimentation « CA » suite à la détection d'un arc électrique. Dans cet autre mode de réalisation, le courant modulé par un signal spécifique appliqué à chacun des modules M1-M3 est superposé au courant de fonctionnement du système électrique. Le courant modulé est de préférence d'amplitude plus faible que le courant de fonctionnement. Le courant modulé peut être appliqué en permanence, ou de manière intermittente. Dans cet autre mode de réalisation, un éventuel arc électrique sera alors détecté en même temps que sera identifié le module défectueux à l'origine de l'arc.

Un exemple de signal spécifique utilisé dans l'invention pour venir moduler un courant appliqué à un module du système électrique est une séquence de code pseudo-aléatoire. On peut ainsi avoir recours par exemple à un code de Gold ou un code de Kasami, ces codes présentant de très bonnes propriétés de corrélation et pouvant être générés avec une complexité maîtrisée.

A titre d'exemple illustratif, un code de Gold est une séquence pseudo aléatoire résultant de la somme modulo 2 de deux séquences à longueur maximales (de longueur n) de même période Lc et de même rythme. On note n la taille du registre à décalage, et on a $Lc=2^n-1$. La somme de ces deux séquences engendre une famille de codes dont les versions numériques possèdent des fonctions de corrélation telles que l'intercorrélation $K_{cicj}$ (i≠j) ne prend que trois valeurs possibles et l'autocorrélation $K_{cici}$ ne prend que quatre valeurs possibles (les trois valeurs des intercorrélations, plus une) :

$$pour\ i \neq j,\ K_{c_ic_j}(t) = \begin{cases} -\dfrac{1}{Lc} \\ -\dfrac{1}{Lc}t(n) \\ \dfrac{1}{Lc}[t(n)-2] \end{cases} ;\ K_{c_ic_i}(t) = \begin{cases} 1 \\ -\dfrac{1}{Lc} \\ -\dfrac{1}{Lc}t(n) \\ \dfrac{1}{Lc}[t(n)-2] \end{cases},$$

avec $t(n)=\left[1 + 2^{\frac{n+1}{2}}\right]$ si n est impair, et avec $t(n)=\left[1 + 2^{\frac{n+2}{2}}\right]$ si n est pair. Ainsi pour un code de longueur 1023 :

$$pour\ i \neq j,\ K_{c_ic_j}(t) = \begin{cases} -\dfrac{1}{1023} \\ -\dfrac{65}{1023} \\ \dfrac{65}{1023} \end{cases} ;\ K_{c_ic_i}(t) = \begin{cases} 1 \\ -\dfrac{1}{1023} \\ -\dfrac{65}{1023} \\ \dfrac{65}{1023} \end{cases}.$$

Ainsi, ce type de code d'étalement permet de facilement discriminer un code particulier d'un autre code, et ainsi d'identifier la connexion défectueuse. La détection d'un pic d'autocorrélation est en outre ainsi particulièrement adaptée au calcul du temps de propagation de l'onde acoustique.

**Revendications**

1. Procédé de localisation de défauts dans un système électrique (1) comprenant une pluralité de modules (M1-M3) pouvant être alimentés indépendamment en courant, le procédé comprenant la mesure d'un signal acoustique (SA) qui accompagne un arc électrique généré par un module défectueux (Mj) et étant **caractérisé en ce qu'**il comporte les étapes suivantes :

   - application (ASp) à chacun des modules d'un courant modulé par un signal spécifique (C1-C3) au module,
   - identification (IDMd) d'une signature de l'un des signaux spécifiques dans le signal acoustique mesuré pour identifier le module défectueux (Mj).

2. Procédé selon la revendication 1, dans lequel l'identification d'une signature de l'un des signaux spécifiques dans le signal acoustique mesuré comprend une corrélation du signal acoustique mesuré (SA) avec chacun des signaux spécifiques (C1-C3).

3. Procédé selon la revendication 2, dans lequel l'identification du module défectueux comprend l'identification d'un pic d'autocorrélation parmi les résultats de corrélation du signal acoustique mesuré avec chacun des signaux spécifiques.

**4.** Procédé selon la revendication 3, comprenant en outre une étape de localisation de l'arc électrique par détermination, à partir des résultats d'autocorrélation du signal acoustique mesuré avec le signal spécifique associé au module défectueux, du temps de propagation de l'onde acoustique depuis l'arc électrique jusqu'à un capteur acoustique (3) réalisant la mesure du signal acoustique.

**5.** Procédé selon la revendication 4, comprenant la détermination du temps de propagation de l'onde acoustique depuis l'arc électrique jusqu'à au moins trois capteurs acoustiques réalisant la mesure du signal acoustique, et une triangulation des temps de propagation ainsi déterminés.

**6.** Procédé selon l'une des revendications 1 à 5, dans lequel un signal spécifique à un module est une séquence de code pseudo-aléatoire, par exemple un code de Gold ou un code de Kasami.

**7.** Procédé selon l'une des revendications 2 à 6, dans lequel chacun des signaux spécifiques est mis en forme par une forme d'onde rectangulaire avant corrélation avec le signal acoustique mesuré.

**8.** Procédé selon l'une des revendications 1 à 7, comprenant les étapes préalables de détection (Mnt) d'un arc électrique, et de coupure de l'alimentation (CA) du système électrique.

**9.** Procédé selon l'une des revendications 1 à 7, dans lequel le courant modulé appliqué à chacun des modules est superposé à un courant de fonctionnement du système électrique.

**10.** Système électrique (1) comprenant une pluralité de modules (M1-M3) pouvant être alimentés indépendamment en courant et un capteur acoustique (3) permettant la mesure d'un signal acoustique (SA) qui accompagne un arc électrique généré par un module défectueux (Mj), le système étant **caractérisé en ce qu'**il comporte en outre :

- un module d'application (5) à chacun des modules (M1-M3) d'un courant modulé par un signal spécifique (C1-C3) au module,
- une unité de traitement (6) configurée pour identifier une signature de l'un des signaux spécifiques dans le signal acoustique mesuré par le capteur acoustique pour identifier le module défectueux.

**Patentansprüche**

**1.** Verfahren zur Lokalisierung von Fehlern in einem elektrischen System (1), welches eine Vielzahl von Modulen (M1-M3) aufweist, welche unabhängig voneinander mit Strom versorgt werden können, wobei das Verfahren die Messung eines akustischen Signals (SA) umfasst, welches mit einem von einem defekten Modul (Mj) erzeugten elektrischen Lichtbogen einhergeht, und wobei das Verfahren **dadurch gekennzeichnet ist, dass** es die folgenden Schritte umfasst:

- Anlegen (ASp) eines Stroms an jedes der Module, wobei der Strom durch ein spezifisches Signal (C1-C3) am Modul moduliert wird;
- Identifikation (IDMd) einer Signatur eines der spezifischen Signale in dem akustischen Signal, welches zur Identifikation des defekten Moduls (Mj) gemessen wird.

**2.** Verfahren nach Anspruch 1, in welchem die Identifikation einer Signatur eines der spezifischen Signale in dem gemessenen akustischen Signal eine Korrelation des gemessenen akustischen Signals (SA) mit jedem der spezifischen Signale (C1-C3) umfasst.

**3.** Verfahren nach Anspruch 2, in welchem die Identifikation des defekten Moduls die Identifikation eines Autokorrelations-Spitzenwerts unter den Ergebnissen der Korrelation des gemessenen akustischen Signals mit jedem der spezifischen Signale umfasst.

**4.** Verfahren nach Anspruch 3, welches darüber hinaus einen Schritt der Lokalisierung des elektrischen Lichtbogens umfasst, indem ab den Ergebnissen der Autokorrelation des gemessen akustischen Signals mit dem spezifischen Signal, welches dem defekten Modul zugeordnet wird, die Ausbreitungszeit der akustischen Welle seit dem elektrischen Lichtbogen bis zu einem akustischen Sensor (3), der die Messung des akustischen Signals realisiert, bestimmt wird.

5.  Verfahren nach Anspruch 4, welches die Bestimmung der Ausbreitungszeit der akustischen Welle seit dem elektrischen Lichtbogen bis zumindest drei akustischen Sensoren, welche die Messung des akustischen Signals realisieren, und eine Triangulation der auf diese Art bestimmten Ausbreitungszeiten umfasst.

6.  Verfahren nach einem der Ansprüche 1 bis 5, in welchem ein spezifisches Signal an einem Modul eine Pseudozufalls-Codesequenz ist, beispielsweise ein Gold-Code oder ein Kasami-Code.

7.  Verfahren nach einem der Ansprüche 2 bis 6, in welchem jedes der spezifischen Signale durch eine Rechteckwelleform vor der Korrelation mit dem gemessenen Signal geformt bzw. formatiert wird.

8.  Verfahren nach einem der Ansprüche 1 bis 7, welches die vorherigen Schritte der Ortung (Mnt) eines elektrischen Lichtbogens sowie die Unterbrechung der Stromversorgung (CA) des elektrischen Systems umfasst.

9.  Verfahren nach einem der Ansprüche 1 bis 7, in welchem der modulierte Strom, welcher an jedes der Module angelegt wird, einem Betriebsstrom des elektrischen Systems überlagert ist.

10. Elektrisches System (1), welches eine Vielzahl von Modulen (M1-M3), welche unabhängig voneinander mit Strom versorgt werden können, sowie einen akustischen Sensor (3) aufweist, welcher die Messung eines akustischen Signals (SA) ermöglicht, das mit einem von einem defekten Modul (Mj) erzeugten elektrischen Lichtbogen einhergeht, wobei das System **dadurch gekennzeichnet ist, dass** es darüber hinaus Folgendes aufweist:

    - ein Modul (5) zum Anlegen eines Stroms an jedes der Module (M1-M3), wobei der Strom durch ein spezifisches Signal (C1-C3) am Modul moduliert wird;
    - eine Recheneinheit bzw. Verarbeitungsanlage (6), welche zur Identifikation einer Signatur eines der spezifischen Signale in dem von dem akustischen Sensor gemessenen akustischen Signal konfiguriert ist, um das defekte Modul zu identifizieren.

### Claims

1.  Method for locating faults in an electrical system (1) comprising a plurality of modules (M1-M3) that can be powered independently with current, the method comprising the measuring of an acoustic signal (SA) that accompanies an electrical arc generated by a defective module (M) and being **characterized in that** it further comprises the following steps:

    - application (Asp) to each of the modules of a current which is modulated by a signal (C1-C3) specific to the module,
    - identification (IDMd) of a signature of one of the specific signals in the measured acoustic signal in order to identify the defective module (Mj).

2.  Method according to claim 1, wherein the identification of a signature of one of the specific signals in the measured acoustic signal comprises calculating a correlation of the measured acoustic signal (SA) with each one of the specific signals (C1-C3).

3.  Method according to claim 2, wherein the identification of the defective module comprises the identification of an auto-correlation peak from among the correlation results of the measured acoustic signal with each one of the specific signals.

4.  Method according to claim 3, further comprising a step of locating the electrical arc by determining, using the auto-correlation results of the measured acoustic signal with the specific signal associated with the defective module, the propagation time of the acoustic wave from the electrical arc to an acoustic sensor (3) taking the measurement of the acoustic signal.

5.  Method according to claim 4, comprising determining the propagation time of the acoustic wave from the electrical arc to at least three acoustic sensors taking the measurement of the acoustic signal, and triangulating of the determined propagation times.

6. Method according to one of claims 1 to 5, wherein a signal specific to a module is a sequence of pseudo-random code, for example a Gold code or a Kasami code.

7. Method according to one of claims 2 to 6, wherein each of the specific signals is formatted by a rectangular waveform before correlation with the acoustic signal measured.

8. Method according to one of claims 1 to 7, comprising the prior steps of detecting (Mnt) an electrical arc, and of cutting off the power (CA) of the electrical system.

9. Method according to one of claim 1 to 7, wherein the modulated current applied to each of the modules is superimposed with an operating current of the electrical system.

10. Electrical system (1) comprising a plurality of modules (M1-M3) that can be powered independently with current and an acoustic sensor(3) enabling the measurement of an acoustic signal (SA) that accompanies an electrical arc generated by a defective module (Mj), wherein the system further comprises:

- a module (5) configured to apply to each of the modules (M1-M3) a current which is modulated by a signal (C1-C3) specific to the module,
- a treatment unit (6) configured to identify a signature of one of the specific signals in the acoustic signal measured by the acoustic sensor in order to identify the defective module.

FIG. 1

FIG. 2

FIG. 3

## RÉFÉRENCES CITÉES DANS LA DESCRIPTION

**Documents brevets cités dans la description**

- US 20120006117 A1
- US 2012327745 A1
- DE 102011009512 A1